# EUROPÄISCHE PATENTSCHRIFT

(11) **EP 2 621 031 B1**
(45) Veröffentlichungstag und Bekanntmachung des Hinweises auf die Patenterteilung: **31.07.2019**
(21) Anmeldenummer: 13000268.6
(22) Anmeldetag: 18.01.2013
(51) Int. Cl.: H01S 3/00, G02F 1/37

(54) **Optikanordnung und Verfahren zum Erzeugen von Lichtpulsen veränderbarer Verzögerung**
Optical assembly and method for generating light pulses with a variable delay
Agencement optique et procédé destinés à générer des impulsions lumineuses à décélération variable

(30) Priorität: 24.01.2012 DE 102012001357
(43) Veröffentlichungstag der Anmeldung: 31.07.2013
(73) Patentinhaber: Menlo Systems GmbH, 82152 Martinsried (DE)
(72) Erfinder: Holzwarth, Ronald, 81679 München (DE); Mei, Michael, 82237 Steinebach (DE); Wilk, Rafal, 82152 Martinsried (DE)
(74) Vertreter: Grünecker Patent- und Rechtsanwälte PartG mbB

(56) Entgegenhaltungen:
- EP-A2- 0 809 335
- JP-A- H09 101 208
- US-A1- 2011 170 171
- R. WILK: "All fiber THz spectrometer for plastics industry", BULLETIN OF THE POLISH ACADEMY OF SCIENCES. TECHNICAL SCIENCES, Bd. 59, Nr. 3, 1. Januar 2011 (2011-01-01) , XP055418489, PL ISSN: 0239-7528, DOI: 10.2478/v10175-011-0034-x

## Beschreibung

Die Erfindung bezieht sich auf eine Optikanordnung gemäß dem Oberbegriff des Anspruchs 1, sowie auf ein entsprechendes Verfahren.

Bekannt ist eine gattungsgemäße Optikanordnung bzw. ein entsprechendes Verfahren unter der Bezeichnung "optical sampling by cavity tuning (OSCAT)" beispielsweise aus der DE 10 2008 026 484 A1, aus dem Artikel "Optical sampling by laser cavity tuning", T. Hochrein, R. Wilk, M. Mei, R. Holzwarth, N. Krumbholz, M. Koch, OPTICS Express 1613, Vol. 18, Nr. 2, Januar 2010, oder aus dem Artikel "OSCAT: Novel Technique for Time-Resolved Experiments Without Moveable Optical Delay Lines", R. Wilk, T. Hochrein, M. Koch, M. Mei, R. Holzwarth, J Infrared Milli Terahz Waves (2011) 32:596-602. Ein vollständig aus Glasfasern aufgebautes THz-Spektrometer, welches auf dem OSCAT-Verfahren basiert, geht ferner aus dem Artikel "All fiber THz spectrometer for plastics industry", R. Wilk, Bulletin of the Polish Academy of Sciences, Technical Sciences, Vol. 59, No. 3, 2011, hervor.

Das Prinzip hinter dem OSCAT-Verfahren beruht darauf, dass eine Pulslichtquelle eine Folge von Lichtpulsen aussendet. Diese Lichtpulse werden an einem Puls- oder Strahlteiler in Folgen von ersten bzw. zweiten sekundären Lichtpulsen aufgeteilt. In dem von den zweiten sekundären Lichtpulsen durchlaufenen Pfad befindet sich eine Verzögerungsstrecke bzw. allgemein ein Verzögerungselement, das für eine zeitliche Verzögerung der zweiten sekundären Laserpulse relativ zu den ersten sekundären Laserpulsen sorgt. Das OSCAT-Verfahren erlaubt es nun, eine zeitliche Verzögerung eines bestimmten zweiten sekundären Lichtpulses relativ zu einem ersten sekundären Lichtpuls variabel einzustellen, selbst wenn die vom Verzögerungselement erzeugte zeitliche Verzögerung der zweiten sekundären Lichtpulse konstant bleibt bzw. wenn die optische Weglänge des Verzögerungselements konstant bleibt. Erreicht wird dies durch eine Veränderung der Repetitionsrate bzw. (synonym) der Pulswiederholrate der Pulslichtquelle. Zu diesem Zweck kann beispielsweise eine Resonatorlänge der Pulslichtquelle variiert werden.

Die einstellbare Verzögerung der beiden Lichtpulse relativ zueinander erlaubt eine Reihe von einzigartigen Anwendungen, beispielsweise im Hinblick auf spektroskopische Untersuchen oder sogenannte Pump-Probe-Experimente, THz Zeitbereichspektroskopie oder auch Fouriertransformspektroskopie. Im Vergleich zu alternativen Systemen zum Erzeugen einer variablen Verzögerung zweier Lichtpulse relativ zueinander bietet das OSCAT-Verfahren enorme Vorteile im Hinblick auf Robustheit sowie geringeren Justageaufwand und geringere Kosten. Beispielsweise wurde in der Vergangenheit eine optische Verzögerungsstrecke mechanisch verändert, meist durch Verschieben eines oder mehrerer Spiegel, um die bewirkte Verzögerung zu verändern. Dies erforderte jedoch einen hohen Justageaufwand und einen unverhältnismäßig hohen Aufwand für die mechanische Präzision der Verschiebung. In einem anderen Verfahren, dem sogenannten "Asynchronous Optical Sampling (ASOPS)", wurden zwei Pulslichtquellen verwendet und elektronisch miteinander synchronisiert. Dies bedeutete jedoch wegen der zwei Pulslichtquellen sehr hohe Kosten sowie einen zusätzlichen Aufwand für die elektronische Synchronisierung. Ein ähnlich aufwendiges Verfahren unter Verwendung zweier synchronischer Laser beschreibt die US 5,778,016 A.

Aufgabe der vorliegenden Erfindung ist es, die herkömmliche Optikanordnung bzw. das herkömmliche Verfahren im Hinblick auf ihre Einsatzmöglichkeiten zu verbessern.

Gelöst wird diese Aufgabe erfindungsgemäß durch eine Optikanordnung mit den Merkmalen des Anspruchs 1 bzw. durch ein Verfahren mit den Merkmalen des Anspruches 8. Vorteilhafte Weiterbildungen der Erfindung sind in den Unteransprüchen angegeben.

Die erfindungsgemäße Optikanordnung umfasst eine Pulslichtquelle zum Erzeugen primärer Lichtpulse. Bei dieser Pulslichtquelle handelt es sich bevorzugt, aber nicht notwendigerweise, um eine kohärente Pulslichtquelle, d.h. um einen gepulsten Laser. Insbesondere könnte es sich um einen amplitudenmodulierten CW-Halbleiterlaser handeln, üblicherweise jedoch um modengekoppelte Laser wie Kurzpuls- oder Ultrakurzpulslaser, beispielsweise Femtosekundenlaser. Alternativ kann als Pulslichtquelle eine Dauerlichtquelle (z.B. ein cw-Laser) mit variierbarer (Amplituden-) Modulationsfrequenz verwendet werden. Diese Pulslichtquelle erzeugt einen Zug von primären Lichtpulsen mit veränderbarer Pulswiederholrate. Dabei ist die Pulswiederholrate bzw. Repetitionrate die Frequenz, mit der die Pulslichtquelle die primären Lichtpulse abgibt. Üblicherweise handelt es sich bei der Pulswiederholrate um das Inverse der Umlaufzeit eines Lichtpulses in einem Resonator der Pulslichtquelle. Synonym zu dem Ausdruck Pulslichtquelle kann im Übrigen auch der Ausdruck Oszillator verwendet werden.

Ein Pulsteiler ist dazu vorgesehen, die primären Lichtpulse in erste und zweite sekundäre Lichtpulse aufzuteilen. Der Begriff Pulsteiler umfasst dabei auch Strahlteiler, die einen ersten Anteil jedes primären Lichtpulses in einen ersten Lichtpfad und den restlichen Anteil des primären Lichtpulses in einen zweiten Lichtpfad lenken. Der Ausdruck Pulsteiler umfasst jedoch auch optische Elemente, bei denen die beiden Lichtpfade zusammenfallen, sodass die beiden sekundären Lichtpulse zwar in einen gemeinsamen Pfad, aber hintereinander gestaffelt vom Pulsteiler abgegeben werden. Lediglich die zweiten sekundären Lichtpulse unterliegen dann einer zeitlichen Verzögerung, die von einem Verzögerungselement bewirkt wird. Die optische Weglänge des Verzögerungselements ist diejenige Weglänge, um die sich die Länge des Lichtpfades der zweiten sekundären Laserpulse von dem der ersten sekundären Laserpulse unterscheidet. Diese Weglängendifferenz ist üblicherweise fest. Die ersten und zweiten sekundären Lichtpulse können anschließend in einen Zielbereich gelenkt, gegebenenfalls in diesen Zielbereich fokussiert werden. Dabei können die Zielbereiche, in die die beiden sekundären Laserpulse gelenkt werden, zusammenfallen oder auseinanderfallen. In einer faserbasierten Ausführung der Optikanordnung kann als Pulsteiler ein Faserkoppler verwendet werden. Der Pulsteiler kann jedoch auch schon in die Pulslichtquelle integriert sein, so dass diese zwei Ausgangsports aufweist, die jeweils die ersten bzw. die zweiten sekundären Lichtpulse emittieren.

Die erfindungsgemäße Optikanordnung sieht nun einen Temperaturstabilisator zum thermischen Stabilisieren des Verzögerungselements vor. Zusätzlich wären eine Temperaturisolierung zum thermischen Isolieren des Verzögerungselements, ein Temperaturkompensator zum Kompensieren einer temperaturabhängigen Veränderung einer optischen Weglänge des Verzögerungselements und/oder ein Regelkreis zum Ermitteln und Kontrollieren einer Drift einer mittleren Pulswiederholrate der Pulslichtquelle denkbar. Diese vier Maßnahmen sind sowohl einzeln, als auch in Kombination dazu geeignet, die mit der Optikanordnung erzielte Präzision der zeitlichen Verzögerung zweier Lichtpulse relativ zueinander deutlich zu erhöhen. Diese Präzision wiederum ist entscheidend für die Genauigkeit und Aussagekraft der mit den verzögerten Lichtpulsen durchgeführten Anwendungen oder Experimente.

Der Temperaturstabilisator bewirkt eine Entkopplung der Temperatur des Verzögerungselements von der Umgebungs- oder Raumtemperatur, indem er eine Möglichkeit vorsieht, die Temperatur des Verzögerungselements auch bei einer Änderung der Umgebungstemperatur stabil zu halten. Beispielsweise könnten für den Temperaturstabilisator eine Solltemperatur und ein Toleranzbereich um die Solltemperatur herum vorgesehen sein, um eine Rückführung der Temperatur des Verzögerungselements auf die Solltemperatur einzuleiten, wenn sich die tatsächliche Temperatur aus dem Toleranzbereich heraus bewegt hat.

Eine Temperaturisolierung des Verzögerungselements kann beispielsweise durch Einfassen des Verzögerungselements in temperaturisolierendes Material wie Styropor oder Styrodur erfolgen. Die Temperaturisolierung bewirkt eine Entkopplung der Temperatur des Verzögerungselements von der Umgebungs- oder Raumtemperatur. Dadurch wird verhindert, dass eine sich ändernde Raumtemperatur auf das Verzögerungselement und insbesondere auf die optische Weglänge des Verzögerungselements und damit auf die von dem Verzögerungselement bewirkte Verzögerung der Lichtpulse Einfluss nimmt. Dazu kann das Verzögerungselement als Glasfaser ausgelegt sein.

Ein Temperaturkompensator wiederum kann eine Änderung der Temperatur des Verzögerungselements hinnehmen. Er bietet jedoch den Vorteil, eine durch die Temperaturerhöhung bewirkte Änderung der optischen Weglänge des Verzögerungselements kompensieren zu können. Beispielsweise könnte eine Temperaturerhöhung zu einer Ausdehnung des Verzögerungselements und damit zu einer Verlängerung der optischen Weglänge führen. Der Temperaturkompensator wäre dazu konfiguriert, diese Verlängerung der optischen Weglänge auszugleichen durch ein Element, das umgekehrt eine Weglängenverkürzung erführe (und umgekehrt).

Die drei vorstehend genannten Varianten beziehen sich alle auf das Verzögerungselement. Zusätzlich wäre es denkbar, mit einem Regelkreis die Pulswiederholrate der Pulslichtquelle zu regeln - vorzugsweise dadurch, die Drift einer mittleren Pulswiederholrate der Pulslichtquelle in einem Regelkreis zu erfassen und die Pulswiederholrate der Pulslichtquelle mittels desselben Regelkreises so kontrollieren, dass eine Drift zu einem möglichst hohen Grad wieder kompensiert bzw. rückgängig gemacht wird. Damit wird berücksichtigt, dass sich eine Änderung der Umgebungstemperatur nicht nur auf die Verzögerungsstrecke, sondern auch auf die Pulslichtquelle selbst auswirken kann.

Wenn eine Temperaturisolierung vorhanden ist, könnte diese zusätzlich zum Verzögerungselement auch noch den Pulsteiler umschließen, vorzugsweise darüber hinaus auch die Pulslichtquelle. Neben dem Verzögerungselement wären damit auch weitere Komponenten der Optikanordnung gegenüber der Umgebungstemperatur thermisch isoliert, sodass eine Änderung der Umgebungstemperatur keinerlei Einfluss mehr auf die Optikanordnung und insbesondere auf die Präzision der Verzögerung der Lichtpulse haben kann.

Wenn ein Temperaturstabilisator vorgesehen ist, weist dieser vorzugsweise einen Temperatursensor sowie mindestens ein Heizelement und/oder mindestens ein Kühlelement auf. Der Temperatursensor ermöglicht eine Automatisierung der Temperaturstabilisation, indem er beispielsweise die Temperatur des Verzögerungselements erfasst. Der Messwert des Temperatursensors kann dann geeignet ausgewertet werden, um ein Heizelement und/oder ein Kühlelement so anzusteuern, dass die Temperatur des Verzögerungselements innerhalb eines Sollbereichs bleibt.

Besonders robust wird die erfindungsgemäße Optikanordnung, wenn sie weitgehend oder sogar vollständig auf Freistrahlstrecken verzichtet und stattdessen faseroptisch konfiguriert ist. Insbesondere könnte es sich auch bei dem Verzögerungselement um eine bestimmte Strecke eines Lichtwellenleiters bzw. einer Lichtleitfaser handeln. In diesem Fall wäre es denkbar, als Temperaturkompensator einen ansteuerbaren Faser-Stretcher vorzusehen. Dieser kann mittels eines geeigneten Aktors, beispielsweise eines Piezo-Aktors, an der Faser des Verzögerungselements angreifen. Wenn sich die Temperatur des Verzögerungselements ändert und sich die Faser dabei ausdehnt oder verkürzt, könnte der Faser-Stretcher eine Verkürzung oder Verlängerung der Faser mit umgekehrtem Vorzeichen bewirken, sodass die optische Weglänge des Verzögerungselements unabhängig von der Temperatur konstant bleibt.

Wenn ein Regelkreis zum Ermitteln und Kontrollieren einer Drift einer mittleren Pulswiderholrate der Pulslichtquelle vorgesehen ist, wird vorzugsweise ein Frequenzdetektor, ein Frequenzzähler oder ein Phasendetektor verwendet, um die Pulswiederholrate der Pulslichtquelle zu ermitteln. In der erfindungsgemäßen Optikanordnung wird die Pulswiederholrate der Pulslichtquelle jedoch gezielt verändert, um die Verzögerung der Lichtpulse zu verändern.

Man kann die Repetionsrate mit Hilfe des Phasendetektors auf einen festen Wert stabilisieren (sog. PLL, phase locked loop). Zum Scannen der Repetitionsrate kann man dann eine Modulation zwischen dem Ausgang des Phasendetektors und dem Eingang der "Lockbox" (PI-Regelkreis) anlegen.

Um die gezielt herbeigeführte Veränderung der Pulswiederholrate im Hinblick auf eine Temperaturkompensation unberücksichtigt zulassen und stattdessen nur eine mittlere Drift der Pulswiederholrate zu messen, kann das Signal von dem Frequenzdetektor, dem Frequenzzähler oder von dem Phasendetektor optional über einen Tiefpassfilter gefiltert werden.

Dieser blockiert die gezielt herbeigeführte Veränderung der Pulswiederholrate, lässt jedoch eine Drift bzw. niederfrequente Änderung der Pulswiederholrate passieren. Das gefilterte Signal kann dann einem Regler zugeführt werden, der über einen geeigneten Aktor, beispielsweise einen Elektrooptischen (EOM)-Modulator, auf die Resonatorlänge der Pulslichtquelle oder über einen Amplitudenmodulator (AM) auf die Dauerstrichquelle und damit auf deren Pulswiederholrate Einfluss nehmen kann.

Wenn ein Frequenzzähler verwendet wird, kann man dessen Gatezeit so wählen, dass das den Tiefpass ersetzt. Dann könnte man den Zähler auslesen und die Repetitionsrate entsprechend nachstellen

Einen Tiefpass verwendet man am sinnvollsten, wenn man einen Frequenzdetektor einsetzt, also ein Gerät, das eine Spannung in Abhängigkeit von der momentanen Frequenz liefert. Damit ist kein Phasenlock (d.h. eine Kopplung der Phasen) möglich, sondern nur ein Frequenzlock, was im Prinzip etwas ungenauer ist, da nicht die Phase (also direkt die Sinusschwinung) verfolgt wird. Für die meisten Anwendungsfälle dürfte jedoch schon diese Genauigkeit völlig ausreichen.

In einer noch einfacheren Variante beobachtet die Optikanordnung die zeitliche Position des Pulses in dem Experiment. Falls der Puls driftet, regelt das System die Pulswiederholrate nach.

Denkbar ist es auch, dass der Regelkreis einen Funktionsgenerator zum Vorgeben einer konstanten oder variablen externen Referenzfrequenz aufweist. In diesem Fall könnte die externe Referenzfrequenz mit dem den Tiefpassfilter passierenden Signal verglichen und geeignet ausgewertet werden.

Zusätzlich zu den vorstehend beschriebenen Varianten zur Temperaturisolierung, - stabilisierung oder -kompensation oder auch unabhängig davon kann vorgesehen sein, dass die Optikanordnung in dem optischen Weg der ersten und/oder der zweiten sekundären Lichtpulse eines oder mehrere der folgenden Elemente aufweist: Einen Verstärker, einen Abschwächer, ein nicht-lineares Medium, einen Zweite-Harmonische-Erzeuger (second harmonic generator, SHG), einen Pulskompressor, einen Puls-Picker, einen Amplitudenmodulator und/oder einen Dispersionskompensator.

Jedes dieser Elemente und insbesondere Kombinationen dieser Elemente erhöhen die Funktionalität der Optikanordnung beträchtlich. Ein Verstärker kann dabei in Form einer optisch gepumpten und geeignet mit Fremdatomen dotierten Faserstrecke realisiert sein. Dabei sind Varianten denkbar, in denen nur für die ersten oder nur für die zweiten sekundären Lichtpulse jeweils ein Verstärker vorgesehen ist, oder wobei für die ersten und die zweiten sekundären Laserpulse jeweils ein eigener Verstärker vorgesehen ist, um die Spitzenintensität oder die Pulsenergie dieser Pulse zu erhöhen. Denkbar ist ferner auch eine Variante, bei der die ersten und die zweiten sekundären Laserpulse zusammengeführt und in einen gemeinsamen Verstärker geleitet werden, der damit sowohl für die ersten, als auch für die zweiten sekundären Laserpulse vorgesehen ist. Letztere Variante hat den Vorteil, sowohl die ersten, als auch die zweiten sekundären Laserpulse verstärken zu können, ohne einen zweiten Verstärker vorsehen zu müssen. Denkbar ist außerdem eine Variante, in der ein Verstärker als Verzögerungselement eingesetzt wird, wenn der Verstärker selbst eine Verlängerung einer optischen Weglänge und damit eine Verzögerung von Lichtpulsen bewirken kann. Analog gelten alle diese Möglichkeiten auch für einen Abschwächer anstelle eines Verstärkers.

Wenn im Weg der ersten und/oder der zweiten sekundären Laserpulse ein nicht-lineares Medium oder ein Erzeuger für die zweite oder eine höhere Harmonische angeordnet ist, vergrößert dies die Einsatzmöglichkeiten der Optikanordnung weiter, weil mit diesen Elementen die Spektren der vorauseilenden bzw. der verzögerten Laserpulse veränderbar sind.

Weitere neue Einsatzmöglichkeiten ergeben sich, wenn ein Pulskompressor, ein Puls-Picker und/oder ein Amplitudenmodulator vorgesehen werden. Ein Pulskompressor verkürzt die zeitliche Dauer der ersten und/oder der zweiten Lichtpulse.

Damit ist eine Dispersionskompensation der Verzögerungsstrecke selbst nicht mehr nötig, da die Komprimierung "am Ende" durchgeführt wird. Das geht auch (z.B. in einem Freistrahl-Gitterkompressor) mit viel höheren Pulsenergien, als dies in faseroptischen Bauteilen möglich wäre.

Damit ermöglicht er sowohl höhere Spitzenintensitäten der Lichtpulse, als auch eine höhere zeitliche Präzision beispielsweise bei Pump-Probe-Experimenten. Ein Pulspicker ermöglicht das gezielte Herauspicken eines oder mehrerer Lichtpulse, um z.B. die Gesamtbestrahlung einer Probe kontrollieren zu können. Einen Amplitudenmodulator hingegen erlaubt die Variation der Amplituden in einem Zug von Lichtpulsen. Dadurch wird es möglich, am Zielort nicht nur die Verzögerung zwischen zwei Laserpulsen einzustellen, sondern auch die Amplitude der vorlaufenden und/oder der nacheilenden Laserpulse zu verzögern. Dies erlaubt das Gewinnen von sowohl zeit-, als auch intensitätsabhängigen Aussagen einer Probe, in die die ersten und zweiten sekundären Laserpulse gelenkt werden.

Von besonderem Interesse könnte ein Dispersionskompensator sein, der dazu führt, dass entweder die Dispersion der ersten sekundären Laserpulse genau derjenigen der zweite sekundären Laserpulse entspricht, wenn diese jeweils die Optikanordnung verlassen, oder das die Gesamtdispersion der ersten und/oder der zweiten sekundären Laserpulse möglichst nahe bei Null liegt.

Eine erste Möglichkeit für ein Verzögerungselement mit Dispersionskompensation besteht aus der Kopplung zweier oder mehrerer Fasertypen, die entgegengesetzte Dispersionseigenschaften haben, sodass die gesamte Faserstrecke effektiv Null-Dispersion hat. Beispielsweise könnte dafür eine sogenannte IDF (inverse dispersion fiber), eine DCF (dispersion compensating fiber) oder eine SMF (single mode fiber) sowohl in Form einer polarisationserhaltenden, als auch in Form einer nicht-polarisationserhaltenden Faser verwendet werden. Eine zweite Möglichkeit besteht in einer Kombination eines Polarisationsstrahlteilers, eines Zirkulators, nicht-polarisationserhaltender IDF-, DCF-, und SFM-Fasern, λ/4-Wellenplatten und einem Faraday-Rotator. Eine dritte Möglichkeit besteht in der Verwendung eines Fasertyps, der effektiv Null-Dispersion hat, beispielsweise einer Dispersion-Shifted-Fiber (DSF), einer Photonic-Crystal-Fiber, einer Hohlkernfaser (hollow-core-fiber) oder einer Faser mit reduzierten Nicht-Linearitäten, wiederum in Form einer polarisationserhaltenden oder einer nicht-polarisationserhaltenden Faser. Eine vierte Möglichkeit besteht in der Verwendung eines Faser-Bragg-Gitters und einer Single-Mode-Faser sowie eines Zirkulators und eines Strahlteilers. Wiederum kann diese Version polarisationserhaltend oder nicht-polarisationserhaltend ausgeführt sein. Eine fünfte Möglichkeit besteht in einer Kombination eines Reflexionsgitters oder Transmissionsgitters mit Prismen zur Dispersionskompensation der ersten oder einer höheren Ordnung. Eine weitere Möglichkeit besteht in der Verwendung von Faser-Verstärkerstrecken mit nicht-linearer Dispersionsanpassung (Fasenmodulation) oder einer sogenannten parabolischen Pulspropagation.

Die Erfindung bezieht sich des Weiteren auf ein Verfahren zum Erzeugen von Lichtpulsen mit veränderbarer Verzögerungszeit auf der Basis des herkömmlichen OSCAT-Verfahrens. Gemäß dem erfindungsgemäßen Verfahren wird dabei die Temperatur des Verzögerungselements mittels eines Temperaturstabilisators konstant gehalten , wie dies im Detail vorstehend beschrieben wurde. Als technischer Vorteil dieser Maßnahme zeigt sich eine besonders hohe Präzision der zeitlichen Verzögerung zwischen unterschiedlichen Lichtpulsen.

Zusätzlich könnte eine temperaturabhängige Veränderung einer optischen Weglänge des Verzögerungselements mittels eines Temperaturkompensators kompensiert und/oder eine Drift der mittleren Pulswiederholrate der Pulslichtquelle ermittelt und geregelt werden.

Denkbar wäre dabei insbesondere, dass die Pulswiederholrate der Pulslichtquelle mittels eines Frequenzdetektors, eines Frequenzzählers oder eines Phasendetektors ermittelt und ein Signal des Frequenzzählers bzw. des Phasendetektors optional noch mittels eines Tiefpassfilters gefiltert wird, um die niederfrequente Drift der Pulswiederholrate zu ermitteln.

Im Folgenden werden vorteilhafte Ausführungsbeispiele der Erfindung anhand einer Zeichnung näher erläutert.

Im Einzelnen zeigen:
- Figur 1:: eine schematische Darstellung eines ersten Ausführungsbeispiels einer erfindungsgemäßen Optikanordnung,
- Figur 2:: ein Diagramm zur Darstellung der zeitlichen Verzögerung der Pulse,
- Figur 3:: ein zweites Ausführungsbeispiel einer erfindungsgemäßen Optikanordnung,
- Figur 4:: ein Diagramm zur Erläuterung des Betriebs der in Figur 3 gezeigten Optikanordnung,
- Figur 5:: ein weiters Diagramm zur Erläuterung der Betriebsweise der in Figur 3 gezeigten Optikanordnung,
- Figur 6:: ein drittes Ausführungsbeispiel einer erfindungsgemäßen Optikanordnung,
- Figur 7:: ein Diagramm zur Darstellung der Funktionsweise der in Figur 6 gezeigten Optikanordnung,
- Figur 8:: ein viertes Ausführungsbeispiel einer erfindungsgemäßen Optikanordnung,
- Figur 9:: ein fünftes Ausführungsbeispiel einer erfindungsgemäßen Optikanordnung,
- Figuren 10a-10f:: unterschiedliche Varianten von Verzögerungselementen,
- Figur 11:: eine schematische Darstellung eines weiteren Ausführungsbeispiels einer erfindungsgemäßen Optikanordnung und
- Figur 12:: eine schematische Darstellung eines weiteren Ausführungsbeispiels einer erfindungsgemäßen Optikanordnung.

Gleiche Komponenten sind in den Figuren durchgängig mit gleichen Bezugszeichenversehen.

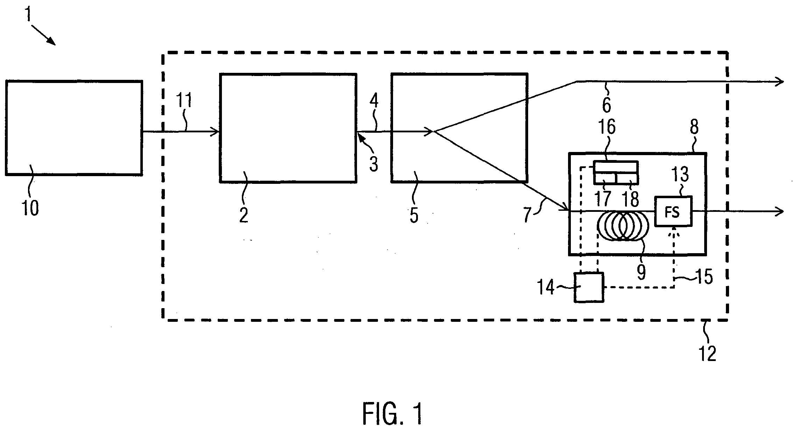

Figur 1 zeigt in schematischer Darstellung ein erstes Ausführungsbeispiel einer erfindungsgemäßen Optikanordnung 1. Diese Optikanordnung 1 ist ausgelegt zum Erzeugen von Lichtpulsen mit einstellbarer oder veränderbarer Verzögerungszeit zwischen unterschiedlichen Pulsen. Zu diesem Zweck verfügt die Optikanordnung 1 über einen Oszillator bzw. eine Pulslichtquelle 2, beispielsweise einen Kurzpuls- oder Ultrakurzpulslaser. Im Ausführungsbeispiel gemäß Figur 1 verfügt die Pulslichtquelle 2 über einen Ausgangsport 3, an dem ein Zug von primären Laserpulsen 4 die Pulslichtquelle 2 verlässt. Die Repetitionsrate bzw. die Pulswiederholrate der primären Lichtpulse 4 ist dabei variabel, beispielsweise indem eine Resonatorlänge der Pulslichtquelle 2 durch Stellelemente wie Piezo-Aktoren verändert wird.

Die Optikanordnung 1 verfügt weiter über einen Strahl- bzw. Pulsteiler 5. Dieser hat die Funktion, die primären Lichtpulse aufzuteilen in erste bzw. zweite sekundäre Lichtpulse 6, 7, die den Pulsteiler 5 auf einem ersten bzw. auf einem räumlich davon getrennten, zweiten Pfad verlassen. Im Pulsteiler 5 wird dabei insbesondere jeder der primären Lichtpulse 4 aufgeteilt in einen ersten Anteil, der den Pulsteiler 5 als erster sekundärer Lichtpuls 6 verlässt, und einen zweiten Anteil, der den Pulsteiler 5 als zweiter sekundärer Lichtpuls 7 verlässt. Beispielsweise könnte als ein solcher Pulsteiler ein faseroptischer oder ein Freistrahl-Strahlteiler, bspw. ein 50:50-Strahlteiler verwendet werden, aber auch ein Strahlteiler mit einem anderen Teilungsverhältnis.

Die Optikanordnung 1 verfügt ferner im Weg der zweiten sekundären Laserpulse über ein Verzögerungselement 8. Das Verzögerungselement 8 umfasst im vorliegenden Ausführungsbeispiel eine Verzögerungs-Faserstrecke 9. Es dient dazu, die zweiten sekundären Lichtpulse 7 relativ zu den ersten sekundären Lichtpulsen 6 zu verzögern, indem die zweiten sekundären Lichtpulse im Vergleich zu den ersten Lichtpulsen zusätzlich die optische Weglänge des Verzögerungselements 8 durchlaufen müssen. Diese optische Weglänge ergibt sich durch den ortsabhängigen Brechungsindex des Verzögerungselements 8, integriert über dessen geometrische Länge.

Bereits mit den vorstehend beschriebenen Komponenten ist die Optikanordnung 1 dazu in der Lage, durch Variation der Repetitionsrate der Pulslichtquelle 2 die zeitliche Verzögerung zwischen den ersten und zweiten sekundären Lichtpulsen 6, 7 variabel einzustellen. Zum Verändern der Repetitionsrate bzw. Pulswiederholrate der Pulslichtquelle verfügt die Optikanordnung 1 über einen Signalgenerator 10. Dieser Signalgenerator 10 erzeugt ein beispielsweise sinusförmiges oder sägezahnförmiges Signal, mit dem die Pulslichtquelle 2 gespeist wird. Das Eingangssignal wird in der Pulslichtquelle 2 umgesetzt in eine korrespondierende Änderung der Pulswiederholrate.

Im Ausführungsbeispiel nach Figur 1 verfügt die Optikanordnung 1 über eine thermische Isolierung 12, beispielsweise eine Hülle aus thermisch isolierendem Material. Die Isolierung 12 isoliert die von ihr umfassten Komponenten thermisch von der Umgebung. Im vorliegenden Ausführungsbeispiel befinden sich die Pulslichtquelle 2, der Pulsteiler 5 und das Verzögerungselement 8 innerhalb der thermischen Isolierung 12. In einer einfacheren Konfiguration würde es jedoch für viele Zwecke schon genügen, wenn allein das Verzögerungselement 8 von einer thermischen Isolierung 12 umgeben wäre, um das Verzögerungselement 8 thermisch zu isolieren. Auf diese Weise nimmt das Verzögerungselement 8 nicht an Änderungen der Umgebungstemperatur teil. Es behält daher seine optische Weglänge, sodass die von der Optikanordnung 1 erzeugte Verzögerung der Lichtpulse präzise einstellbar ist.

Im Ausführungsbeispiel nach Figur 1 verfügt die Optikanordnung ferner über einen Temperaturkompensator 13. Im vorliegenden Ausführungsbeispiel ist dieser Temperaturkompensator 13 als ansteuerbarer Faser-Stretcher FS ausgebildet. Er hat die Aufgabe, eine temperaturabhägige Veränderung einer optischen Weglänge des Verzögerungselements 8 zu kompensieren, falls es trotz der thermischen Isolierung 12 zu einer geringfügigen Temperaturänderung des Verzögerungselements 8 kommen sollte. Wenn sich beispielsweise bei einer Temperaturerhöhung die optische Weglänge der Verzögerungs-Faserstrecke 9 des Verzögerungselements 8 vergrößert, könnte der Temperaturkompensator 13 dies eine geeignete Verkürzung einer Lichtleitfaser ausgleichen, und umgekehrt. Ein Temperaturfühler 14 ist dazu vorgesehen, die Temperatur des Verzögerungselements 8, insbesondere der Verzögerungs-Faserstrecke 9, zu messen. Das Messsignal des Temperaturfühlers 14 kann als Eingangsgröße 15 zum Steuern des TemperaturKompensators 13 verwendet werden. Darüber hinaus kann es verwendet werden zum Steuern eines Temperaturstabilisators 16, der in oder an dem Verzögerungselement 8 vorgesehen ist. Dieser Temperaturstabilisator 16 verfügt über mindestens ein Heizelement 17 und/oder ein Kühlelement 18. Diese Elemente dienen dazu, die Temperatur des Verzögerungselements 8 möglichst in einem um einen Sollwert definierten Sollbereich zu halten. Die Temperaturisolierung 12, der Temperaturstabilisator 16 und der Temperaturkompensator 13 können auch einzeln bzw. unabhängig voneinander in einer erfindungsgemäßen Optikanordnung 1 vorgesehen sein.

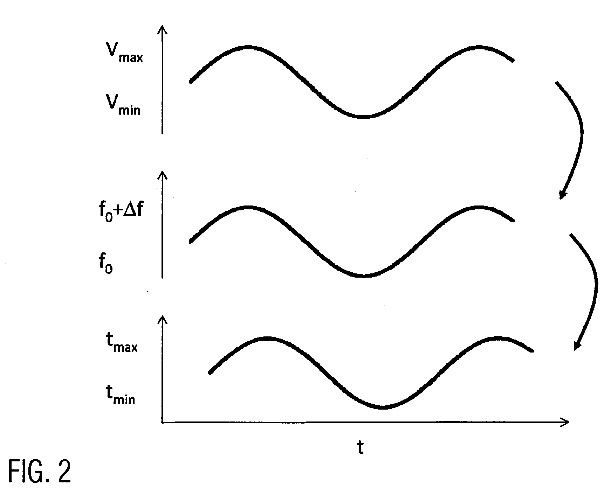

Figur 2 zeigt in schematischer Darstellung das Einstellen einer zeitlichen Verzögerung zweier sekundärer Lichtpulse 6, 7. Zu diesem Zweck zeigt Figur 2 drei Kurven über einer Zeitachse. Die oberste Kurve gibt den Verlauf des Eingangssignals 11 wieder, mit dem die Pulslichtquelle 2 gespeist wird. Dieses Eingangsignal 11 schwankt periodisch zwischen einer Minimalspannung Vₘᵢₙ und einer Maximalspannung Vₘₐₓ.

Die mittlere Kurve zeigt die Veränderung der Pulswiederholrate der Pulslichtquelle 2 über der Zeit. Diese Pulswiederholrate schwankt analog zum Eingangssignal 11 zwischen einem Minimalwert f₀ und einem Maximalwert f₀+Δf.

Die unterste Kurve schließlich zeigt den zeitlichen Abstand zwischen zwei bestimmten sekundären Lichtpulsen 6, 7. Dabei kann es sich um den zeitlichen Abstand zweier sekundärer Pulse 6, 7 handeln, die aus einem gemeinsamen primären Laserpuls 4 entstanden sind, oder um sekundäre Lichtpulse, die aus unterschiedlichen primären Laserpulsen 4 entstanden sind. Zu erkennen ist, dass die zeitliche Verzögerung ebenfalls zwischen einem Minimalwert tₘᵢₙ und einem Maximalwert tₘₐₓ schwankt. Zwischen den beiden oberen Kurven und der unteren Kurve gibt es in Figur 2 jedoch einen gewissen zeitlichen Versatz, der sich aus der Laufzeit der Lichtpulse in der Optikanordnung 1 ergibt.

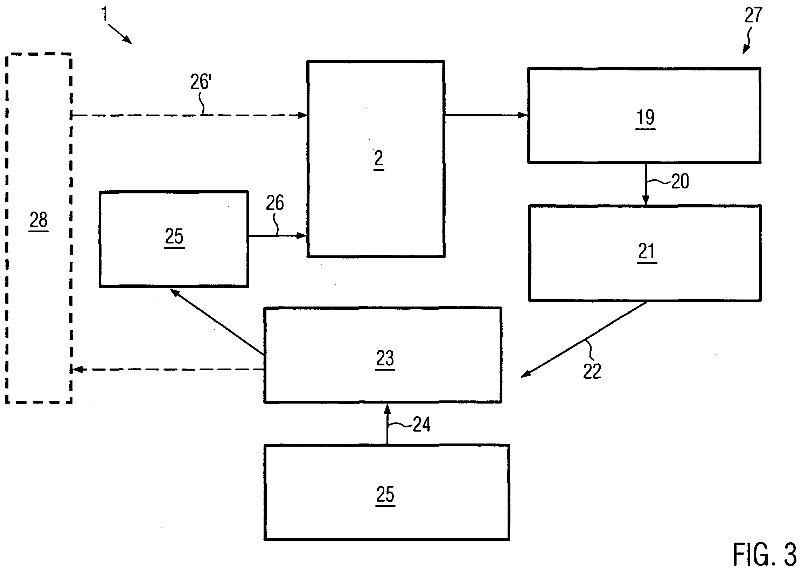

Figur 3 zeigt in schematischer Darstellung ein zweites Ausführungsbeispiel einer erfindungsgemäßen Optikanordnung 1. Der Übersichtlichkeit halber sind hier lediglich die Pulslichtquelle 2 und ihr zugeordnete elektronische Komponenten dargestellt, nicht aber die optischen Pfade, insbesondere also nicht der dennoch vorhandene Pulsteiler 5 und das Verzögerungselement 8. Dies können ebenso konfiguriert sein wie in Figur 1.

Im Ausführungsbeispiel nach Figur 3 ist ein Messgerät 19 vorgesehen, das ein Signal 20 proportional zur Pulswiederholrate des Oszillators bzw. der Pulslichtquelle 2 liefert. Beispielsweise kann dieses Messgerät 19 als Frequenzzähler oder als Phasendetektor ausgebildet sein; Es misst folglich die in Figur 2 mit der mittleren Kurve dargestellte, momentane Pulswiederholrate der Pulslichtquelle 2.

Das Messsignal des Messgeräts 19 wird einem Tiefpassfilter 21 zugeführt. Der Tiefpassfilter blockiert die hochfrequente, gezielt herbeigeführte Änderung der Pulswiederholrate der Pulslichtquelle 2. Stattdessen lässt er lediglich die niederfrequente Drift der mittleren Pulswiederholrate passieren, die sich beispielsweise durch thermische Änderung ergeben kann. Das Driftsignal 22 wird einem Proportional-Integral-Regler 23 zugeführt. Dieser PID-Regler 23 vergleicht das Driftsignal 22 mit einem Referenz-Frequenzsignal 24, welches von einem externen Funktionsgenerator 25 geliefert wird. Die Referenzfrequenz 24 ist konstant.

Das Ausgangssignal des Reglers 23 wird einem Modulator 25 zugeführt, der seinerseits ein Steuersignal 26 zum Steuern der Pulswiederholrate an die Pulslichtquelle 2 übermittelt. Insgesamt ergibt sich ein Regelkreis 27, der das Messgerät 19, den Tiefpassfilter 21, den Regler 23 und den Modulator 25 umfasst. Mit gestrichelten Linien ist dargestellt, dass optional ein Schrittmotortreiber 28 vorgesehen sein kann, der als Eingangssignal ebenfalls das Signal des Reglers 23 erhält, und der seinerseits ein Steuersignal 26' an die Pulslichtquelle 2 übermittelt, beispielsweise zum Einstellen eines die Resonatorlänge und damit die Pulswiederholrate bestimmenden Schrittmotors.

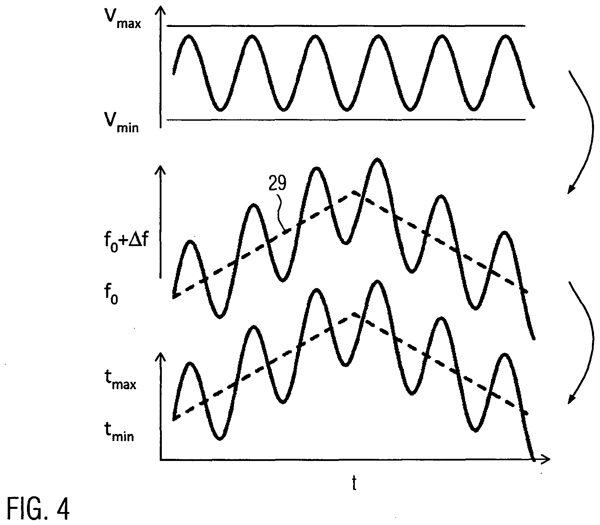

Die Betriebsweise der Optikanordnung 1 gemäß Figur 3 wird schematisch anhand von Figur 4 ersichtlich. Diese zeigt ein Diagramm, das analog zum Zeitdiagramm gemäß Figur 2 ist und ebenfalls in einer oberen Kurve die Eingangsspannung an der Pulslichtquelle 2 darstellt. Diese Eingangsspannung schwankt wieder periodisch bzw. sinusförmig zwischen einem Minimalwert Vₘᵢₙ und einem Maximalwert Vₘₐₓ.

In der mittleren Kurve ist dargestellt, wie sich die Pulswiederholrate ändert, wenn die Temperatur der Pulslichtquelle 2 ansteigt bzw. abfällt. Während die Frequenz der induzierten Änderungen der Pulswiederholrate und die Amplitude dieser induzierten Änderungen konstant bleibt, ändert sich der Mittelwert der Pulswiederholrate. Die Trendlinie des Mittelwerts der Pulsweiderholrate ist in Figur 4 mit 29 bezeichnet. Sie steigt zunächst an, um anschließend bei einem Anstieg der Temperatur wieder abzufallen.

Einen entsprechenden Verlauf zeigt damit auch die unterste Kurve, die die zeitliche Verzögerung zwischen zwei sekundären Laserpulsen 6, 7 wiedergibt. Auch hier steigt der Mittelwert der zeitlichen Verzögerung zunächst an, um anschließend wieder abzufallen. Diese Veränderung der mittleren und damit auch der maximalen oder minimalen Verzögerungszeit ist unerwünscht, da sie die Präzision der zeitlichen Verzögerung für anschließende Anwendungen beeinträchtigt.

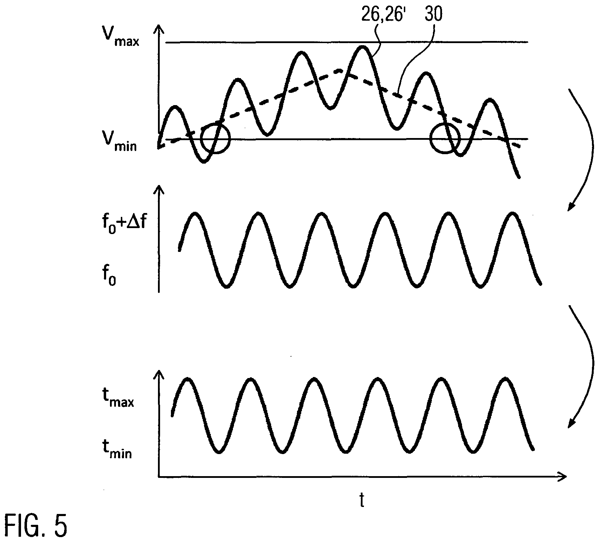

Abhilfe für dieses Problem schafft die in Figur 3 dargestellte Konfiguration der Optikanordnung 1 - wie in Figur 5 dargestellt. Mittels des Regelkreises 27 wird bewirkt, dass die Eingangsspannung, d.h. das Steuersignal 26, 26' nicht nur periodisch zwischen einem Minimalwert Vₘᵢₙ und einem Maximalwert Vₘₐₓ schwankt, sondern dass der Mittelwert 30 des Steuersignals 26, 26' entsprechend der ermittelten Drift driftet, um die temperaturbedingte Änderung der Pulswiederholrate zu kompensieren. Das Ergebnis zeigt sich in der mittleren Kurve in Figur 5, wonach die Pulswiederholrate wie gewünscht periodisch schwankt, ohne jedoch eine ansteigende oder abfallende Drift (wie in Figur 4) zu zeigen. Folglich ist auch die in der unteren Kurve dargestellte zeitliche Verzögerung präzise, d.h. ohne eine Drift nach oben oder nach unten.

In der Optikanordnung 1 wird die Resonatorlänge der Pulslichtquelle 2 mittels eines Piezo-Aktors verändert. Für diesen-Piezo-Aktor darf die Steuerspannung 26 einen vorgegebenen Spannungsbereich oft nicht unter- oder überschreiten. Mit Kreisen ist in der ersten Kurve in Figur 5 eine Situation dargestellt, in der die Steuerspannung 26, diesen erlaubten Bereich unterschreiten würde. Für diesen Fall ist es vorteilhaft, wenn die Optikanordnung 1 einen Schrittmotor aufweist, der über den Schrittmotortreiber 28 angesteuert wird und eine vergleichsweise grobe Änderung der Resonatorlänge der Pulslichtquelle 2 erlaubt. Anschließend kann die Feinsteuerung der Resonatorlänge und damit der Pulswiederrate wieder durch den Piezoaktor erfolgen.

Im Ergebnis zeigt Figur 5 in der mittleren Kurve, dass der Mittelwert der Pulswiederholrate konstant ist. An der unteren Kurve in Figur 5 zeigt sich, dass auch der Mittelwert der zeitlichen Verzögerung der Pulse konstant ist.

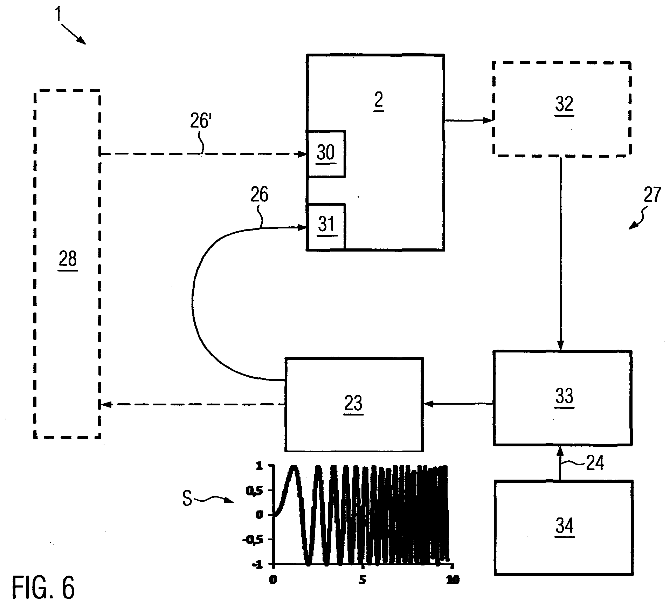

Figur 6 zeigt ein weiteres Ausführungsbeispiel für die Regelung der Pulslichtquelle 2 in der erfindungsgemäßen Optikanordnung 1. Hier ist schematisch dargestellt, dass die Pulslichtquelle 2 (wie auch bereits in den vorangehenden Ausführungsbeispielen) einen Schrittmotor 30 für eine Grobeinstellung der Resonatorlänge (und damit der Pulswiederholrate) aufweist, und einen Piezo-Aktor 31 zur Feineinstellung der Resonatorlänge und damit der Pulswiederholrate. Der Schrittmotor 30 wird durch das Steuersignal 26' angesteuert, das von dem Schrittmotortreiber 28 geliefert wird.

Die Optikanordnung 1 verfügt über einen Frequenzteiler 32, der die Pulswiederholrate des Ozillators bzw. der Pulslichtquelle 2 elektronisch und/oder optisch ermittelt und durch einen vorgegebenen Wert teilt. Das Signal des Frequenzteilers 32 wird einem Phasendetektor 33 zugeleitet, der als weiteres Eingangssignal das Signal eines frequenzmodulierten Funktionsgenerators 34 erhält. Aus diesen beiden Eingangssignalen generiert der Phasendetektor 33 ein Signal, das einem Regler 23 zugeführt wird, der wiederum als PID-Regler konfiguriert sein kann. Unterhalb des PID-Reglers 23 ist in Figur 6 das Ausgangssignal 24 des Funktionsgenerators 34 dargestellt. Das Ausgangssignal des Reglers 23 wird als Steuersignal 26 sowohl dem Piezo-Aktor 31 der Pulslichtquelle 2 zugeleitet, als auch dem Schrittmotortreiber 28.

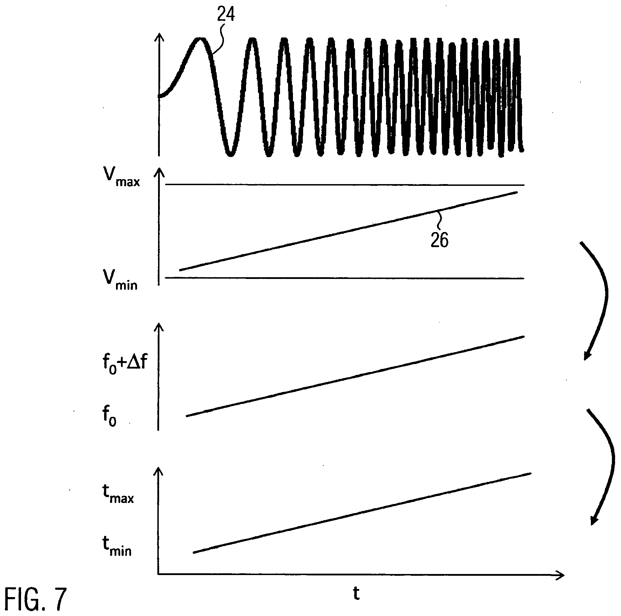

Von dem vorangehenden Ausführungsbeispiel unterscheidet sich das Ausführungsbeispiel nach Figur 6 folglich in der Frequenzmodulation der vom Funktionsgenerator 34 bereitgestellten Referenzfrequenz 24. Das Ergebnis dieser Konfiguration ist in Figur 7 dargestellt, die den Verlauf von vier Kurven über der Zeit darstellt. Die oberste Kurve repräsentiert das frequenzmodulierte Referenzsignal 24, d.h. das Ausgangssignal des Funktionsgenerators 33. Durch den in Figur 6 dargestellten Regelkreis 27, insbesondere durch den Phasendetektor 34 und den nachgeordneten Regel 23, wird daraus das als zweite Kurve in Figur 7 dargestellte Steuersignal 26 generiert, das dem Piezo-Aktor 31 zugeleitet wird. Dieses Steuersignal steigt linear von einer Minimalfrequenz Vₘᵢₙ zu einer Maximalfrequenz Vₘₐₓ an. Ebenso linear ändert sich damit die Resonatorlänge der Pulslichtquelle 2 und damit die Pulswiederholrate. Sie steigt linear von einem Minimalwert f₀ bis auf einen Maximalwert f₀+Δf an, wenn der Piezoaktor 31 die Resonatorlänge verringert. Dargestellt ist dies in der dritten Kurve in Figur 7. Die unterste Kurve in Figur 7 zeigt schließlich die Auswirkung der sich verändernden Pulswiederholrate auf die Verzögerungszeit zwischen zwei unterschiedlichen Lichtpulsen. Sie steigt linear von einem Minimalwert tₘᵢₙ auf einen Maximalwert tₘₐₓ.

Diese Konfiguration der Optikanordnung 1 erlaubt es folglich, durch die Variation der Frequenz des Referenzsignals 24 die zeitliche Verzögerung nicht nur periodisch schwankend, sondern mit beliebiger Charakteristik zu verändern, beispielsweise linear ansteigend oder abfallend. Denkbar wäre eine beliebige Referenzsignalcharakteristik, die z.B eine grobe Messung in einem uninteressanten Zeitbereich (schnelle Referenzfrequenzänderung) und eine präzise Messung (langsamere Referenzfrequenzänderung) in einem interessanten Zeitbereich ermöglicht. Über die Rate der Frequenzänderung des Referenzsignals 24 kann dabei gezielt der Anstieg des Steuersignals 26, der Pulswiederholrate und der Verzögerungszeit beeinflusst werden, da die Pulswiederholrate der Pulslichtquelle 2 der modulierten Referenzfrequenz 24 folgt. Diese Konfiguration der Optikanordnung 1 erlaubt ferner ein sehr schnelles Messverfahren, bei dem die Pulswiederholrate durch den Piezo-Aktor 31 gesteuert wird. Die langsame Drift der Pulswiederholrate kann hingegen durch den Schrittmotor 30 korrigiert werden.

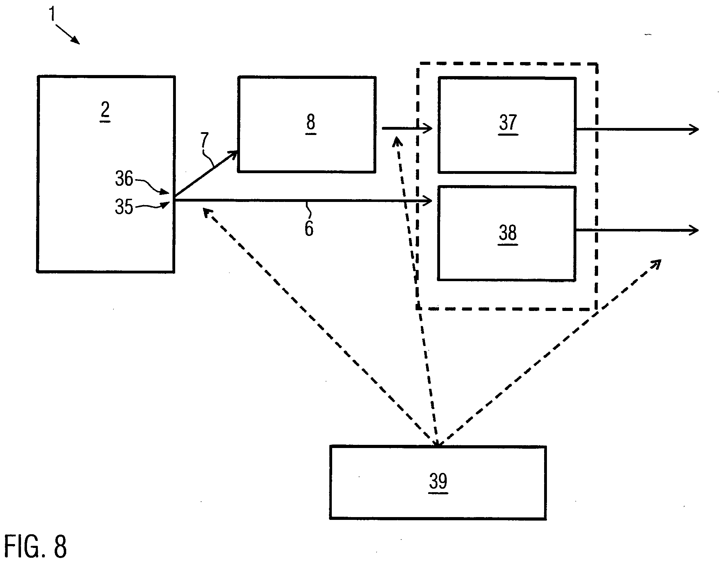

Figur 8 zeigt eine weitere Variante der erfindungsgemäßen Optikanordnung 1 in schematischer Darstellung. In dieser Konfiguration ist der Pulsteiler 5 bereits in die Pulslichtquelle 2 integriert. Die Pulslichtquelle 2 hat folglich zwei verschiedene Ausgangsports 35, 36, an denen die ersten bzw. die zweiten sekundären Lichtpulse 6, 7 die Pulslichtquelle 2 verlassen. Lediglich die zweiten sekundären Lichtpulse 7 werden relativ zu den ersten sekundären Lichtpulsen durch das Verzögerungselement 8 verzögert, bei dem es sich wiederum um eine Verzögerungs-Faserstrecke 9 handeln kann.

Im Ausführungsbeispiel nach Figur 8 sind darüber hinaus zwei optische Verstärker 37, 38 vorgesehen. Der erste Verstärker 37 wird von den verzögerten zweiten sekundären Lichtpulsen 7 durchlaufen, während der zweite Verstärker 38 von den ersten sekundären Lichtpulsen 6 durchlaufen wird. In einer ersten Variante sind die Verstärker 37, 38 baugleich, sodass sie ihrerseits nicht zu einer weiteren Verzögerung der zweiten sekundären Lichtpulse 7 relativ zu den ersten sekundären Lichtpulsen 6 führen. In einer anderen Konfiguration hingegen sind die Verstärker 37, 38 unterschiedlich konfiguriert, sodass sie zu der Verzögerung der Lichtpulse beitragen.

Mit gestrichelten Pfeilen ist in Figur 8 angedeutet, an welchen Stellen der Optikanordnung 1 optional Dispersionskompensationsmittel 39 angeordnet werden können. Auf diese Dispersionskompensationsmittel wird später noch genauer eingegangen werden.

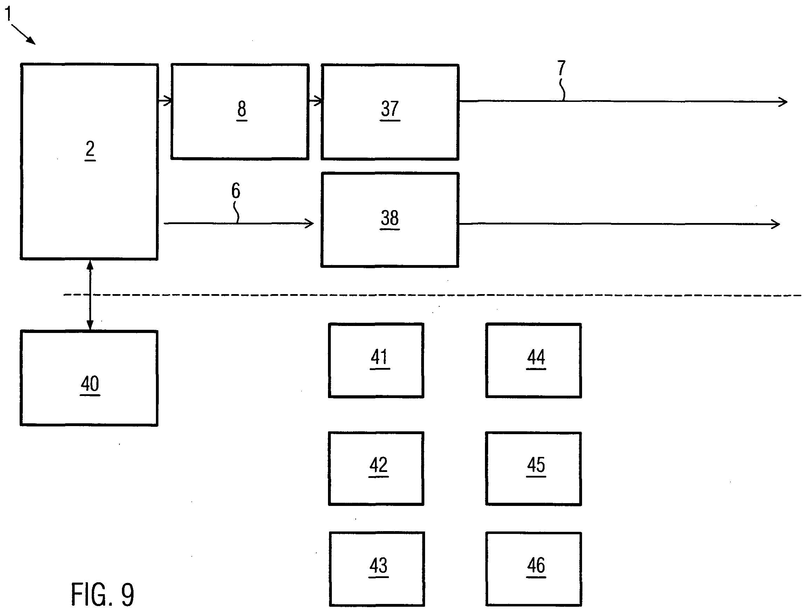

Figur 9 zeigt in schematischer Darstellung weitere Konfigurationsmöglichkeiten der erfindungsgemäßen Optikanordnung 1. Die Grundkonfiguration dieser Optikanordnung 1 oberhalb der gestrichelten Linie in Figur 9 entspricht derjenigen in Figur 8. Unterhalb der gestrichelten Linie sind jedoch weitere Bauteile dargestellt, die optional in die Optikanordnung 1 integriert werden können. Eine elektronische Komponente, die in die Optikanordnung 1 integriert werden kann, ist ein Trigger-Generator 40. Er kann mit der Pulslichtquelle 2 verbunden werden und dient der Datenerfassung.

Weiter rechts zeigt Figur 9 verschiedene Komponenten, die zusätzlich oder anstelle der Verstärker 37, 38 in den Lichtwegen der ersten bzw. der zweiten sekundären Lichtpulse 6, 7 vorgesehen sein können. Bei diesen optionalen vorhandenen optischen oder elektronischen Komponenten handelt es sich um einen Zweite-Harmonische-Erzeuger (second harmonic generator, SHG) 41, einen Amplitudenmodulator 42, einen Puls-Picker 43, ein nicht-lineares Medium 44, einen Puls-Kompressor 45 oder einen Abschwächer 46. Jedes dieser Bauteile erlaubt eine verbesserte Variation der erzeugten Lichtpulse z.B. im Hinblick auf ihre Frequenz, ihre Pulsenergie oder ihre Pulsdauer, oder eine Verbesserung der Präzision der mit der Optikanordnung 1 erzielten Verzögerung zwischen unterschiedlichen Lichtpulsen.

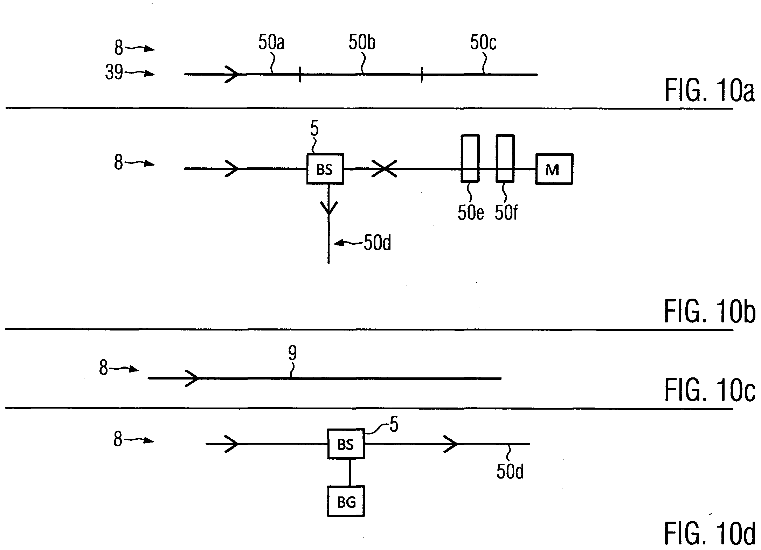

Die Figuren 10a bis 10f stellen verschiedene Varianten des in der erfindungsgemäßen Optikanordnung 1 einsetzbaren Verzögerungselements 8 dar. Figur 10a zeigt eine erste Konfiguration, bei der eine Verzögerungs-Faserstrecke 9 als Verzögerungselement 8 eingesetzt wird, die gleichzeitig als Dispersionskompensationsmittel 39 dient. Für diesen Zweck sind zwei oder mehrere Fasertypen 50a, 50b, 50c unterschiedlicher Dispersionseigenschaften miteinander gekoppelt, sodass die Faserstrecke 9 insgesamt effektiv Null-Dispersion hat. Insbesondere können dafür sogenannte IDF-Fasern 50a (inverse dispersion fiber), DCF-Fasern 50b (dispersion compensating fiber) und/oder SMF-Fasern 50c (single-mode-fiber) sowohl in polarisationserhaltender, als auch in nicht-polarisationserhaltender Konfiguration verwendet werden.

Figur 10b zeigt eine zweite Variante eines Verzögerungselements 8. Hier gelangen die primären Laserpulse 4 auf einen Pulsteiler 5, der als Polarisations-Strahlteiler BS konfiguriert ist. Ein erster Anteil gelangt in Form von primären sekundären Lichtpulsen 6 direkt zu einem Ausgang 50d. Ein zweiter Anteil gelangt in Form von zweiten sekundären Lichtpulsen 7 zu einem Spiegel M und von dort wieder zurück auf den Pulsteiler 5, bevor auch diese zweiten sekundären Lichtpulse 7 vom Pulsteiler 5 zum Ausgang 50d geleitet werden. Die Verzögerungsstrecke besteht hier im zweimaligen Durchlaufen der Strecke zwischen dem Pulsteiler 5 und dem Spiegel M. Diese Strecke kann sowohl Dispersionskompensationsmittel 39 umfassen, als auch optische Elemente wie λ/4-Wellenplatten 50e oder Faraday-Rotatoren 50f, um die Polarisation der zweiten sekundären Lichtpulse 7 so zu beeinflussen, dass sie möglichst verlustfrei vom Pulsteiler 5 zum Ausgang 50d gelenkt werden.

In einer vergleichsweise simplen Konfiguration gemäß Figur 10c wird als Verzögerungs-Faserstrecke 9 für das Verzögerungselement 8 eine Lichtleitfaser verwendet, die effektiv Nulldispersion hat, z.B. eine Dispersion-Shifted-Faser, eine Photonic-Crystal-Fiber, eine Hollow-Core-Fiber oder eine Faser mit reduzierten Nichtlinearitäten.

Figur 10d zeigt eine Variante des Verzögerungselements 8, in der ein Teil 7des Lichts vom Pulsteiler 5 auf einen schmalbandigen Spiegel geworfen wird, insbesondere ein Faser-Bragg-Gitter BG, der das Licht zurück auf den Pulsteiler 5 reflektiert. Dort werden diese Lichtpulse 7 gemeinsam mit dem den Pulsteiler 5 ungehindert durchlaufenden Strahlanteilen 6 zum Ausgang 50d gelenkt. Sowohl in diesem Ausführungsbeispiel, als auch im Ausführungsbeispiel nach Figur 10b können im Verzögerungselement 8 optische Zirkulatoren eingesetzt werden.

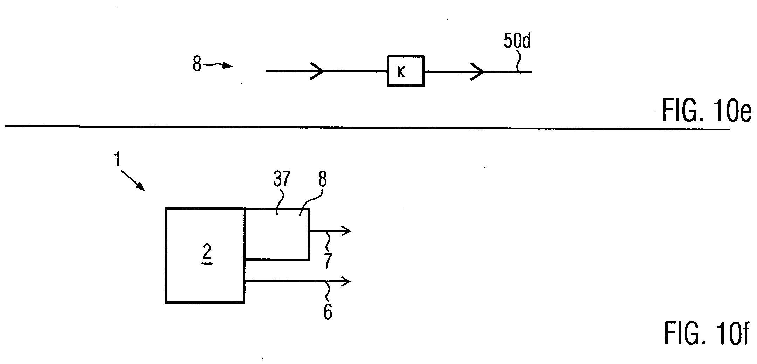

Figur 10e zeigt eine weitere Variante eines Verzögerungselements 8 für die erfindungsgemäße Optikanordnung 1. In dieser Variante führt eine optische Faser zu einem Reflexionsgitter, einem Transmissionsgitter oder einer Prismenkombination K. Eine Gruppe von Prismen könnte dabei gleichzeitig als Dispersionskompensationsmittel 39 dienen.

Schließlich zeigt Figur 10f eine Konfiguration einer Optikanordnung 1, bei der lediglich im Pfad des zweiten sekundären Lichtpulses 7 ein Verstärker 37 vorgesehen ist. Dieser Verstärker 37 bewirkt einen Weglängenunterschied für die zweiten sekundären Lichtpulse 7 relativ zu den ersten sekundären Lichtpulsen 6 und stellt somit das Verzögerungselement 8 dar.

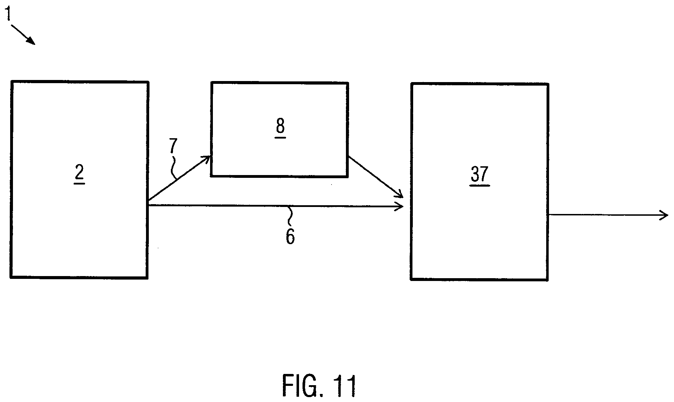

Figur 11 zeigt eine Ausführungsvariante der Optikanordnung 1, bei der die zweiten sekundären Lichtpulse 7 nach dem Durchlaufen des Verzögerungselements 8 wieder mit den ersten sekundären Lichtpulsen 6 zusammengeführt werden, bevor beide Gruppen von sekundären Lichtpulsen 6, 7 in einen gemeinsamen optischen Verstärker 37 geleitet werden. Dieser gemeinsame Verstärker 37 ist folglich dazu eingerichtet, sowohl die ersten sekundären Lichtpulse 6, als auch die zweiten sekundären Lichtpulse 7 zu verstärken. Gegenüber der Konfiguration in Figur 8 bietet dies den Vorteil, auf einen der beiden opti-, schen Verstärker 38 verzichten zu können, was die Optikanordnung 1 weniger komplex und damit deutlich robuster macht.

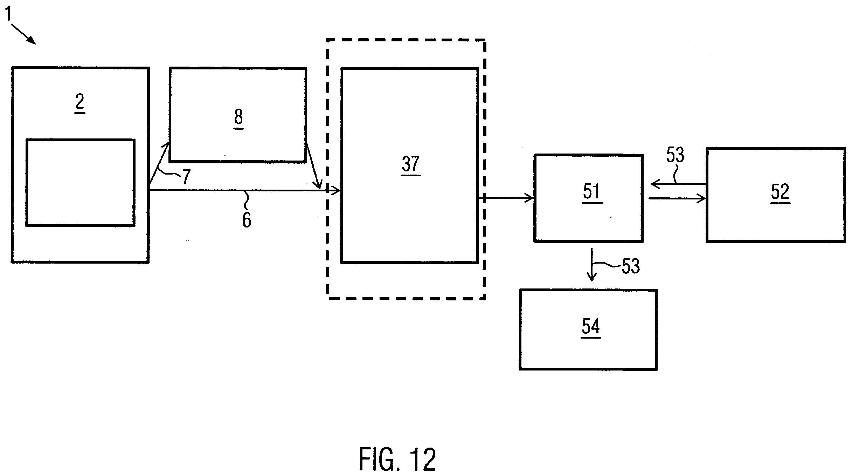

In schematischer Form zeigt Figur 12 eine Anwendung der in Figur 11 dargestellten Optikanordnung 1. Nach dem Durchlaufen des gemeinsamen optischen Verstärkers 37 gelangen sowohl die ersten, als auch die zweiten sekundären Lichtpulse 6, 7 auf einen Polarisationsstrahlteiler bzw. einen Zirkulator 51. Dieser lenkt die sekundären Lichtpulse 6, 7 in einen Experimentaufbau 52, beispielsweise einen Pump-Probe-Experimentaufbau. Signalstrahlung 52, die vom Experimentaufbau 52 zurück auf den Zirkulator 51 gelangt, wird von dort zu einem Detektor 54 geleitet. Aus der Veränderung der Signalstrahlung 53 mit der Veränderung der zeitlichen Verzögerung zwischen den ersten und zweiten sekundären Lichtpulse 6, 7 können Rückschlüsse auf eine untersuchte Probe gezogen werden. Der Experimentaufbau 52 kann auch einen Terahertz-Sender und/oder einen Terahertz-Empfänger umfassen.

Alternativ zu einem Zirkulator kann man einen 50:50-Strahlteiler verwenden oder eine Kombination aus einem Polarisationsstrahlteiler (PBS) und einer λ/4-Wellenplatte. Polarisationserhaltene Zirkulatoren umfassen üblicherweise einen PBS und A/4-Wellenplatten oder einen Faraday-Rotator.

Schließlich sei angemerkt, dass Regelkreise 27 der vorstehend beschriebenen Konfigurationen auch unabhängig von der Messung einer Drift der mittleren Pulswiederholrate eingesetzt werden könnten (also z.B. auch in der thermisch isolierten oder stabilisierten Ausführung der Optikanordnung), um auf ideale Weise die Pulswiederholrate einstellen und steuern zu können.

## Patentansprüche

1. Optikanordnung (1) mit einer Pulslichtquelle (2) zum Erzeugen primärer Lichtpulse (4), einem Pulsteiler (5) zum Aufteilen der primären Lichtpulse (4) in erste und zweite sekundäre Lichtpulse (6, 7), und einem Verzögerungselement (8) zum Verzögern der zweiten sekundären Lichtpulse (7) relativ zu den ersten sekundären Lichtpulsen (6), wobei die Pulswiederholrate der Pulslichtquelle (2) veränderbar ist, **dadurch gekennzeichnet, dass** die Optikanordnung (1) einen Temperaturstabilisator (16) zum thermischen Stabilisieren des Verzögerungselements (8) aufweist, wobei der Temperaturstabilisator (16) einen Temperatursensor (14) sowie mindestens ein Heizelement (17) und/oder mindestens ein Kühlelement (18) aufweist.

2. Optikanordnung nach Anspruch 1, **dadurch gekennzeichnet, dass** die Optikanordnung (1) ferner
- eine Temperaturisolierung (12) zum thermischen Isolieren des Verzögerungselements (8), und/oder
- einen Temperaturkompensator (13) zum Kompensieren einer temperaturabhängigen Veränderung einer optischen Weglänge des Verzögerungselements (8) und/oder
- einen Regelkreis (27) zum Regeln der Pulswiederholrate der Pulslichtquelle, vorzugsweise zum Ermitteln und Kontrollieren einer Drift einer mittleren Pulswiederholrate der Pulslichtquelle (2),
aufweist.

3. Optikanordnung nach Anspruch 2, **dadurch gekennzeichnet, dass** die Temperaturisolierung (12) zusätzlich zum Verzögerungselement (8) auch den Pulsteiler (5) umschließt, vorzugsweise auch die Pulslichtquelle (2).

4. Optikanordnung nach einem der Ansprüche 2 oder 3, **dadurch gekennzeichnet, dass** der Regelkreis (27) einen Frequenzdetektor (19), einen Frequenzzähler (19) oder einen Phasendetektor (19, 34) aufweist.

5. Optikanordnung nach einem der Ansprüche 2 bis 4, **dadurch gekennzeichnet, dass** der Regelkreis (27) einen Funktionsgenerator (25, 33) zum Vorgeben einer externen Referenzfrequenz (24) aufweist.

6. Optikanordnung (1) nach einem der vorangehenden Ansprüche, **dadurch gekennzeichnet, dass** die Optikanordnung (1) in dem optischen Weg der ersten und/oder der zweiten sekundären Lichtpulse (6, 7) eines oder mehrere der folgenden Elemente aufweist: einen Verstärker (37, 38), einen Abschwächer (46), ein Nichtlineares Medium (44), einen Zweite-Harmonische-Erzeuger, SHG, (41), einen Pulskompressor (45), einen Puls-Picker (43), einen Amplitudenmodulator (42), oder einen Dispersionskompensator (39).

7. Optikanordnung nach einem der vorangehenden Ansprüche, **dadurch gekennzeichnet, dass** ein gemeinsamer Verstärker (37) für die ersten und die zweiten sekundären Lichtpulse (6, 7) vorgesehen ist.

8. Verfahren zum Erzeugen von Lichtpulsen (6, 7) mit veränderbarer Verzögerungszeit zwischen unterschiedlichen Lichtpulsen (6, 7), mit folgenden Schritten:
- Erzeugen primärer Lichtpulse (4) mit einer Pulslichtquelle (2),
- Aufteilen der primären Lichtpulse (4) in erste und zweite sekundäre Lichtpulse (6, 7) mittels eines Pulsteilers (5),
- Verzögern der zweiten sekundären Lichtpulse (7) relativ zu den ersten sekundären Lichtpulsen (6) mittels eines Verzögerungselements (8), und
- Verändern einer Pulswiederholrate der Pulslichtquelle (2),
**dadurch gekennzeichnet, dass**
- die Temperatur des Verzögerungselements (8) mittels eines Temperaturstabilisators (16) konstant gehalten wird, wobei der Temperaturstabilisator (16) einen Temperatursensor (14) sowie mindestens ein Heizelement (17) und/oder mindestens ein Kühlelement (18) aufweist.

9. Verfahren nach Anspruch 8, **dadurch gekennzeichnet, dass**
- eine temperaturabhängige Veränderung einer optischen Weglänge des Verzögerungselements (8) mittels eines Temperaturkompensators (13) kompensiert wird und/oder
- eine Drift einer mittleren Pulswiederholrate der Pulslichtquelle (2) ermittelt und geregelt wird.

10. Verfahren nach Anspruch 8 oder 9, **dadurch gekennzeichnet, dass** die Pulswiederholrate der Pulslichtquelle (2) mittels eines Frequenzdetektors (19), eines Frequenzzählers (19) oder eines Phasendetektors (19, 34) ermittelt wird.

## Claims

1. Optical assembly (1) comprising a pulsed light source (2) for generating primary light pulses (4), a pulse splitter (5) for splitting said primary light pulses (4) into first and second secondary light pulses (6, 7), and a delay element (8) for delaying said second secondary light pulses (7) relative to said first secondary light pulses (6), where the pulse repetition rate of said pulsed light source (2) is variable, **characterized in that** said optical assembly (1) comprises a temperature stabilizer (16) for thermally stabilizing said delay element (8), wherein said temperature stabilizer (16) comprises a temperature sensor (14) and at least one heating element (17) and/or at least one cooling element (18).

2. Optical assembly according to claim 1, **characterized in that** said optical assembly (1) further comprises
- a temperature insulation (12) for thermally insulating said delay element (8), and / or
- a temperature compensator (13) for compensating a temperature-dependent change of an optical path length of said delay element (8) and / or
- a control circuit (27) for controlling said pulse repetition rate of said pulsed light source, preferably for detecting and controlling a drift of a mean pulse repetition rate of said pulsed light source (2).

3. Optical assembly according to claim 2, **characterized in that** said temperature insulation (12) in addition to said delay element (8) also encloses said pulse splitter (5), preferably also said pulsed light source (2).

4. Optical assembly according to one of claims 2 or 3, **characterized in that** said control circuit (27) comprises a frequency detector (19), a frequency counter (19) or a phase detector (19, 34).

5. Optical assembly according to one of claims 2 to 4, **characterized in that** said control circuit (27) comprises a function generator (25, 33) for pre-determining an external reference frequency (24).

6. Optical assembly (1) according to one of the preceding claims, **characterized in that** said optical assembly (1) in the optical path of said first and / or said second secondary light pulses (6, 7) comprises one or more of the following elements: an amplifier (37, 38), an attenuator (46), a non-linear medium (44), a second-harmonic generator, SHG, (41), a pulse compressor (45), a pulse picker (43), an amplitude modulator (42), or a dispersion compensator (39).

7. Optical assembly according to one of the preceding claims, **characterized in that** a common amplifier (37) is provided for said first and said second secondary light pulses (6, 7).

8. Method for generating light pulses (6, 7) with a variable delay between different light pulses (6, 7), comprising the following steps:
- generating primary light pulses (4) with a pulsed light source (2),
- splitting said primary light pulses (4) into first and second secondary light pulses (6, 7) by a pulse splitter (5),
- delaying said second secondary light pulses (7) relative to said first secondary light pulses (6) by a delay element (8), and changing a pulse repetition rate of said pulsed light source (2),
**characterized in that**
- the temperature of said delay element (8) is maintained constant by a temperature stabilizer (16), wherein said temperature stabilizer (16) comprises a temperature sensor (12) and at least one heating element (17) and / or at least one cooling element (16).

9. Method according to claim 8, **characterized in that**
- a temperature-dependent change of an optical path length of said delay element (8) is compensated by a temperature compensator (13) and / or
- a drift of a mean pulse repetition rate of said pulsed light source (2) is determined and controlled.

10. Method according to claim 8 or 9, **characterized in that** said pulse repetition rate of said pulsed light source (2) is determined by a frequency detector (19), a frequency counter (19) or a phase detector (19, 34).

## Revendications

1. Agencement optique (1) comprenant une source d'impulsions de lumière (2) pour produire des impulsions de lumière primaires (4), un diviseur d'impulsions (5) pour subdiviser les impulsions de lumière primaires (4) en premières et deuxièmes impulsions de lumière secondaires (6, 7), et un élément de retard (8) pour retarder les deuxièmes impulsions de lumière secondaires (7) par rapport aux premières impulsions de lumière secondaires (6), le taux de répétition des impulsions de la source d'impulsions de lumière (2) étant susceptible de varier,
**caractérisé en ce que** l'agencement optique (1) comporte un stabilisateur de température (16) pour la stabilisation thermique de l'élément de retard (8), le stabilisateur de température (16) comportant un capteur de température (14) ainsi qu'au moins un élément chauffant (17) et/ou au moins un élément de refroidissement (18).

2. Agencement optique selon la revendication 1, **caractérisé en ce que** l'agencement optique (1) comporte par ailleurs :
- une isolation thermique (12) pour isoler thermiquement l'élément de retard (8), et/ou
- un compensateur de température (13) pour compenser une variation, fonction de la température, d'une longueur de parcours optique de l'élément de retard (8), et/ou
- un circuit de régulation (27) pour réguler le taux de répétition d'impulsions de la source d'impulsions de lumière, de préférence pour déterminer et contrôler une dérive ou tendance d'un taux de répétition d'impulsions moyen de la source d'impulsions de lumière (2).

3. Agencement optique selon la revendication 2, **caractérisé en ce que** l'isolation thermique (12) enferme en plus de l'élément de retard (8), également le diviseur d'impulsions (5), et de préférence également la source d'impulsions de lumière (2).

4. Agencement optique selon l'une des revendications 2 ou 3, **caractérisé en ce que** le circuit de régulation (27) comporte un détecteur de fréquence (19), un compteur de fréquence (19) ou un détecteur de phase (19, 34).

5. Agencement optique selon l'une des revendications 2 à 4, **caractérisé en ce que** le circuit de régulation (27) comporte un générateur de fonction (25, 33) pour prescrire une fréquence de référence externe (24).

6. Agencement optique (1) selon l'une des revendications précédentes, **caractérisé en ce que** l'agencement optique (1) comporte dans le parcours optique des premières et/ou deuxièmes impulsions de lumière secondaires (6, 7), un ou plusieurs des éléments suivants : un amplificateur (37, 38), un atténuateur (46), un milieu non linéaire (44), un générateur de seconde harmonique SHG (41), un compresseur d'impulsions (45), un sélecteur d'impulsions (43), un modulateur d'amplitude (42), ou un compensateur de dispersion (39).

7. Agencement optique selon l'une des revendications précédentes, **caractérisé en ce qu'**il est prévu un amplificateur commun (37) pour les premières et les deuxièmes impulsions de lumière secondaires (6, 7).

8. Procédé pour produire des impulsions de lumière (6, 7) avec un temps de retard susceptible de varier entre des impulsions de lumière (6, 7) différentes, comprenant les étapes suivantes consistant à :
- produire des impulsions de lumière primaires (4) à l'aide d'une source d'impulsions de lumière (2),
- subdiviser les impulsions de lumière primaires (4) en premières et deuxièmes impulsions de lumière secondaires (6, 7) au moyen d'un diviseur d'impulsions (5),
- retarder les deuxièmes impulsions de lumière secondaires (7) par rapport aux premières impulsions de lumière secondaires (6) au moyen d'un élément de retard (8), et
- faire varier un taux de répétition d'impulsions de la source d'impulsions de lumière (2),
**caractérisé en ce que**
- l'on maintient constante la température de l'élément de retard (8) au moyen d'un stabilisateur de température (16), le stabilisateur de température (16) comportant un capteur de température (14) ainsi qu'au moins un élément chauffant (17) et/ou au moins un élément de refroidissement (18).

9. Procédé selon la revendication 8, **caractérisé en ce que**
- l'on compense une variation en fonction de la température, d'une longueur de parcours optique de l'élément de retard (8), au moyen d'un compensateur de température (13), et/ou
- l'on détermine et régule une dérive ou tendance d'un taux de répétition d'impulsions, moyen de la source d'impulsions de lumière (2).

10. Procédé selon la revendication 8 ou la revendication 9, **caractérisé en ce que** l'on détermine le taux de répétition d'impulsions de la source d'impulsions de lumière (2), au moyen d'un détecteur de fréquence (19), d'un compteur de fréquence (19) ou d'un détecteur de phase (19, 34).
